# EUROPEAN PATENT APPLICATION

(11) **EP 4 563 731 A1**
(43) Date of publication of application: **04.06.2025**
(21) Application number: 23845062.1
(22) Date of filing: 31.05.2023
(51) Int. Cl.: C30B 15/14, C30B 29/06

(54) **HEATER FOR SINGLE CRYSTAL FURNACE AND SINGLE CRYSTAL FURNACE**

(30) Priority: 25.07.2022 CN 202221949180 U; 27.09.2022 CN 202222570281 U
(71) Applicant: Longi Green Energy Technology Co., Ltd., Xi'an, Shaanxi 710100 (CN)
(72) Inventor: ZHANG, Chaoguang, Shaanxi 710100 (CN); WANG, Shasha, Shaanxi 710100 (CN); CHENG, Lei, Shaanxi 710100 (CN); WEN, Yongfei, Shaanxi 710100 (CN); CHENG, Lu, Shaanxi 710100 (CN); MA, Shaolin, Shaanxi 710100 (CN); DING, Biao, Shaanxi 710100 (CN)
(74) Representative: Pfenning, Meinig & Partner mbB
(86) International application number: PCT/CN2023/097422
(87) International publication number: WO 2024/021849

(57) **Abstract**

This application provides a heater for a single crystal furnace and a single crystal furnace. The heater for a single crystal furnace includes a heating cylinder and an electrode footplate. The heating cylinder is a cylindrical structure arranged around a crucible in the single crystal furnace. The electrode footplate includes a first electrode footplate and a second electrode footplate. the first electrode footplate supports one side of the heating cylinder and is configured to connect to a first electrode of a power supply; the second electrode footplate supports another side of the heating cylinder and is configured to connect to a second electrode of the power supply; and A resistivity of the electrode footplate is less than a resistivity of the heating cylinder. According to the heater provided in the embodiments of this application, a heating amount of the heating cylinder can be effectively improved while a heating amount of the electrode footplate is reduced, thereby reducing oxygen content in a head of a produced crystal rod, and facilitating cost reduction and on-site handling

## Description

### CROSS-REFERENCE TO RELATED APPLICATIONS

This application claims priorities to Chinese Patent Application No. 202222570281.7, field with the China National Intellectual Administration Property on September 27, 2022 and entitled "HEATER FOR SINGLE CRYSTAL FURNACE AND SINGLE CRYSTAL FURNACE", and Chinese Patent Application No. 202221949180.4, filed with the China National Intellectual Administration Property on July 25, 2022 and entitled "HEATER AND SINGLE CRYSTAL FURNACE", which are incorporated herein by reference in their entities.

### TECHNICAL FIELD

This application relates to the technical field of crystalline silicon manufacturing devices, and in particular, to a heater for a single crystal furnace and a single crystal furnace.

### BACKGROUND

At present, to meet the strong production capacity requirement of the solar photovoltaic industry for monocrystalline silicon crystal rod, the sizes of thermal fields and monocrystalline silicon crystal rods are continuously increased, leading to a continuous increase in oxygen content in the crystal rod. The increase in the oxygen content in the crystal rod not only leads to occurrence of a phenomenon of "concentric circles" in the solar cell to reduce the efficiency and a service life of the solar cell, but also increases the crystal pulling costs of the monocrystalline silicon crystal rod.

For the problem of excessively high oxygen content in the head of the crystal rod, in the related art, the oxygen content in the head of the crystal rod is generally reduced by reducing the speed of crucible rotation during crystal pulling and using an oxygen reduction heater.

However, the reduction of the speed of crucible rotation leads to an increase in the temperature fluctuation and a wire breakage rate during crystal pulling. The use of the oxygen reduction heater requires greatly reducing a height of a heating region of the heater, leading to excessive concentration of heat, resulting in a shortened service life of the heater and increased crystal pulling costs.

### SUMMARY

An objective of this application is to provide a heater for a single crystal furnace and a single crystal furnace, to resolve the problems that a heater used in an existing single crystal growth process cannot effectively take into account both the quality of a crystal rod and the production costs.

To resolve the foregoing problems, this application is implemented through the following technical solutions:
This application provides a heater for a single crystal furnace, including a heating cylinder and an electrode footplate, where
the heating cylinder is a cylindrical structure arranged around a crucible in the single crystal furnace;
the electrode footplate includes a first electrode footplate and a second electrode footplate;
the first electrode footplate supports one side of the heating cylinder and is configured to connect to a first electrode of a power supply;
the second electrode footplate supports another side of the heating cylinder and is configured to connect to a second electrode of the power supply; and
a resistivity of the electrode footplate is less than a resistivity of the heating cylinder.

Optionally, in the heater for a single crystal furnace, the resistivity of the heating cylinder is greater than or equal to 11 µΩ•m, and the resistivity of the electrode footplate is less than or equal to 10 µΩ•m.

Optionally, in the heater for a single crystal furnace, the resistivity of the heating cylinder is greater than or equal to 12 µΩ•m, and the resistivity of the electrode footplate is less than or equal to 9 µΩ•m.

Optionally, in the heater for a single crystal furnace, a thickness of the heating cylinder in a radial direction ranges from 15 mm to 30 mm; a height of the heating cylinder in an axial direction ranges from 150 mm to 400 mm; and
cross-sectional thicknesses of the first electrode footplate and the second electrode footplate both range from 25 mm to 40 mm, and cross-sectional widths of the first electrode footplate and the second electrode footplate both range from 70 mm to 95 mm.

Optionally, in the heater for a single crystal furnace, the heating cylinder includes a plurality of splicing members, and the plurality of splicing members are connected to each other and combine to form the heating cylinder.

Optionally, in the heater for a single crystal furnace, along an axial direction of the heating cylinder, projections of the splicing members are all in a shape of an arc.

Optionally, in the heater for a single crystal furnace, a central angle of the arc ranges from 60 degrees to 180 degrees.

Optionally, in the heater for a single crystal furnace, the splicing members correspond to the same central angle.

Optionally, in the heater for a single crystal furnace, an upper portion of each of the splicing members is thinned, and a thickness of a thinned region of the upper portion of each of the splicing members is not less than 12 mm.

Optionally, in the heater for a single crystal furnace, each of the splicing members is gradually thinned from a lower end to an upper end, and a minimum thickness of each of the splicing members is not less than 12 mm.

Optionally, in the heater for a single crystal furnace, the first electrode footplate and the second electrode footplate are respectively fixedly connected to two splicing members distributed opposite to each other.

This application provides another heater for a single crystal furnace, including a heating cylinder and an electrode footplate, where
the heating cylinder is a cylindrical structure arranged around a crucible in the single crystal furnace;
the electrode footplate includes a first electrode footplate and a second electrode footplate;
the first electrode footplate supports one side of the heating cylinder and is configured to connect to a first electrode of a power supply;
the second electrode footplate supports another side of the heating cylinder and is configured to connect to a second electrode of the power supply; and
a resistance ratio of the heating cylinder to the electrode footplate is (0.85-1):(0-0.15).

Optionally, in the heater for a single crystal furnace, an absolute value of a resistance value of the heating cylinder ranges from 25 mΩ to 60 mΩ, and an absolute value of a resistance value of the electrode footplate ranges from 0 mΩ to 1 mΩ.

This application further provides a single crystal furnace, including a furnace body and the heater for a single crystal furnace described above installed in the furnace body.

Compared with the related art, this application includes the following advantages:
The heater for a single crystal furnace in this application includes a heating cylinder and an electrode footplate; the heating cylinder is a cylindrical structure arranged around a crucible in the single crystal furnace; the electrode footplate includes a first electrode footplate and a second electrode footplate; the first electrode footplate supports one side of the heating cylinder and is configured to connect to a first electrode of a power supply; the second electrode footplate supports another side of the heating cylinder and is configured to connect to a second electrode of the power supply; and a resistivity of the electrode footplate is less than a resistivity of the heating cylinder. The resistivity of the heating cylinder and the resistivity of the electrode footplate of the heater are distinguished, a blank material with a low resistivity is used to form the electrode footplate, and a blank material with a high resistivity is used to form the heating cylinder. Therefore, there is no need to reduce a height of the heating cylinder and increase a thickness of the electrode footplate, and a heating amount of the heating cylinder can be effectively improved while a heating amount of the electrode footplate is reduced, thereby reducing oxygen content in a head of a produced crystal rod, and facilitating cost reduction and on-site handling.

This application provides a heater, including: a heating cylinder, configured to cover an outer side of a crucible of a single crystal furnace to heat the crucible, where the heating cylinder includes a first end surface and a second end surface opposite to the first end surface, the heating cylinder further includes a first slot extending from the first end surface toward the second end surface and a second slot extending from the second end surface toward the first end surface, the first slot and the second slot are alternately arranged along a circumferential direction of the heating cylinder, and a distance between an end of the second slot and the first end surface is less than a distance between an end of the first slot and the second end surface; and an electrode footplate, configured to be connected to an electrode of the single crystal furnace, where the electrode footplate is connected to an end of the heating cylinder close to the second end surface.

Optionally, a length of the first slot is not less than 81% of a length of the heating cylinder, and a length of the second slot is not greater than 89% of the length of the heating cylinder.

Optionally, the distance between the end of the first slot and the second end surface is not less than 50 mm, and the distance between the end of the second slot and the first end surface is not greater than 45 mm.

Optionally, a width of the first slot and a width of the second slot both range from 10 mm to 40 mm.

Optionally, a thickness of the electrode footplate ranges from 32 mm to 40 mm, and a width of the electrode footplate ranges from 150 mm to 175 mm.

Optionally, the heating cylinder includes a plurality of splicing members, and every two adjacent splicing members are connected through a connection plate, so that the plurality of splicing members combine to form the cylindrical structure.

Optionally, resistivities of the splicing members and the connection plate are consistent.

Optionally, the heating cylinder is integrally formed.

Optionally, the heating cylinder is made of a graphite material or a carbon-carbon material.

Based on the foregoing technical solutions, this application further provides a single crystal furnace, including a crucible and the heater according to the foregoing technical solutions, where a length of the heating cylinder is 0.35 times to 0.5 times a height of the crucible.

Through the foregoing technical solutions, in the heater provided in this application, by causing the distance between the end of the second slot and the first end surface to be less than the distance between the end of the first slot and the second end surface, a position of a high temperature region of the heating cylinder is adjusted, so that the position of the high temperature region is moved upward as a whole to be away from a bottom of the crucible while ensuring that the total resistance and a heating amount of the heating cylinder are unchanged, to reduce baking to the bottom of the crucible, and reduce a temperature of the bottom of the crucible, thereby reducing the oxygen content in the head of the crystal rod while ensuring the crystal pulling stability and the production efficiency. The single crystal furnace provided in this application has the same technical effects as the heater in the foregoing technical solutions. To avoid unnecessary repetition, details are not described herein again. In addition, since the length of the heating cylinder of the heater is 0.35 times to 0.5 times the total height of the crucible, the length of the heating cylinder provided in this application is less than a length of a conventional heating cylinder, so that the high temperature region of the heating cylinder can be away from the bottom of the crucible, thereby reducing the oxygen content in the head of the crystal rod.

It should be understood that, the foregoing general description and the following detailed description are merely exemplary and explanatory, and cannot limit this application.

### BRIEF DESCRIPTION OF THE DRAWINGS

The accompanying drawings described herein are used to provide a further understanding of this application, and form a part of this application. Exemplary embodiments of this application and description thereof are used to explain this application, and do not constitute any inappropriate limitation to this application. In the accompanying drawings:
FIG. 1 is a schematic structural diagram of a heater for a single crystal furnace according to an embodiment of this application;
FIG. 2 is a diagram of comparison between oxygen content in a crystal rod grown by a heater provided in an embodiment of this application and oxygen content in a crystal rod grown by a heater in the related art;
FIG. 3 is a schematic structural diagram of a heater according to a specific implementation of this application;
FIG. 4 is a schematic structural diagram of a heating cylinder according to a specific implementation of this application; and
FIG. 5 is a schematic structural diagram of a support leg according to a specific implementation of this application.

### DETAILED DESCRIPTION

The following clearly and completely describes the technical solutions in the embodiments of this application with reference to the accompanying drawings in the embodiments of this application. Apparently, the described embodiments are merely some embodiments of this application rather than all of the embodiments. All other embodiments obtained by a person of ordinary skill in the art based on the embodiments of this application without making creative efforts shall fall within the protection scope of this application.

It should be understood that, throughout the specification, "one embodiment" or "an embodiment" means that specific features, structures, or characteristics described with reference to the embodiment are included in at least one embodiment of this application. Therefore, appearances of "in one embodiment" or "in an embodiment" in various places throughout the specification do not necessarily refer to the same embodiment. In addition, the specific features, structures, or characteristics may be combined in one or more embodiments in any appropriate manner.

A heater for a single crystal furnace mainly generates heat in a manner of generating heat by energizing a resistor, and conducts the heat through a crucible to heat a silicon material in the crucible, so as to generate silicon liquid for growing monocrystalline silicon. Resistivities of a heating cylinder and an electrode footplate of an existing heater are the same. In order to reduce the resistance of the electrode footplate, it is necessary to reduce a height of the footplate and thicken a thickness of the electrode footplate, which easily leads to an excessively low heater. However, an excessively low height of the heater leads to deterioration of the crystal pulling stability and an increased wire breakage rate. In addition, due to excessive concentration of generated heat, a service life of the heater is easily shortened, and the costs of a thermal field are increased.

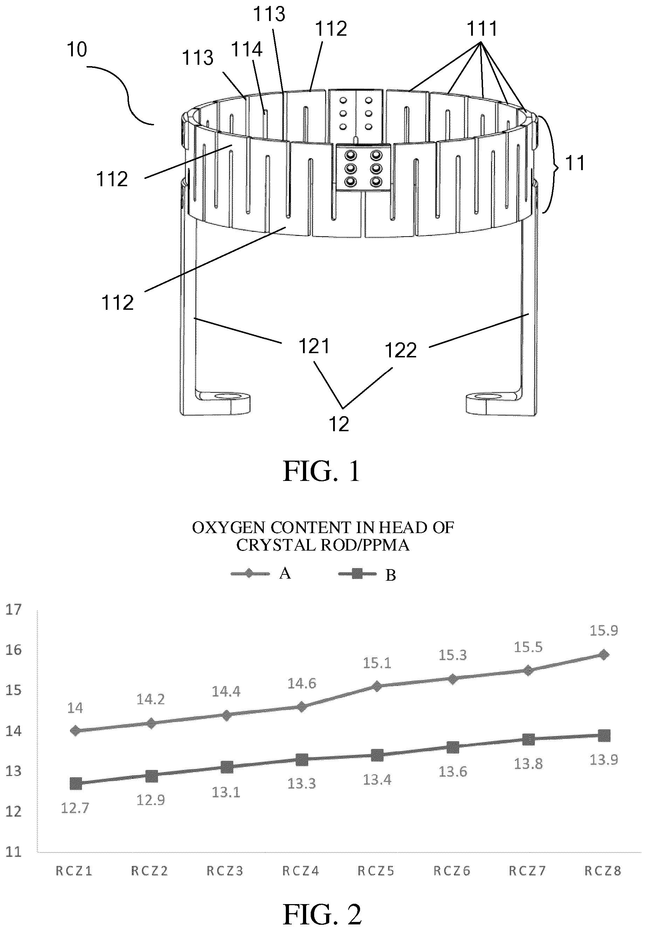

In view of the foregoing problems, an embodiment of this application provides a heater 10 for a single crystal furnace. As shown in FIG. 1, a heating cylinder 11 and an electrode footplate 12 are included. The heating cylinder 11 is a cylindrical structure arranged around a crucible in the single crystal furnace; the electrode footplate 12 includes a first electrode footplate 121 and a second electrode footplate 122; the first electrode footplate 121 supports one side of the heating cylinder 11 and is configured to connect to a first electrode of a power supply; the second electrode footplate 122 supports another side of the heating cylinder 11 and is configured to connect to a second electrode of the power supply; and a resistivity of the electrode footplate 12 is less than a resistivity of the heating cylinder 11.

In the heater 10 for a single crystal furnace provided in this application, the heating cylinder 11 is a cylindrical structure arranged around the crucible in the single crystal furnace. In other words, the heating cylinder 11 has an accommodating space for accommodating the crucible. Two ends of the first electrode footplate 121 in the electrode footplate 12 are respectively connected to one side of the heating cylinder 11 and the first electrode of the power supply, and two ends of the second electrode footplate 122 in the electrode footplate 12 are respectively connected to another side of the heating cylinder 11 and the second electrode of the power supply. Therefore, the heating cylinder 11 can be electrically connected to the power supply through the electrode footplate 12 to generate heat, to heat the crucible placed inside the accommodating space of the heating cylinder 11.

The resistivity of the heating cylinder 11 and the resistivity of the electrode footplate 12 of the heater 10 are distinguished, a blank material with a low resistivity is used to form the electrode footplate 12, and a blank material with a high resistivity is used to form the heating cylinder 11. Therefore, there is no need to reduce a height of the heating cylinder 11 and increase a thickness of the electrode footplate 12, and a heating amount of the heating cylinder 11 can be effectively improved while a heating amount of the electrode footplate 12 is reduced, thereby reducing oxygen content in a head of a produced crystal rod, and facilitating cost reduction and on-site handling since the thickness of the electrode footplate 12 does not need to be additionally increased.

Oxygen in the crystal rod mainly comes from oxygen generated by reaction of the crucible and fused silicon at a high temperature: SiO₂ + Si → SiO. It can be seen that a high-temperature environment is an important factor affecting the oxygen content in the crystal rod. Compared with a design in which the resistivity of the heating cylinder 11 and the resistivity of the electrode footplate 12 in the heater in the related art are the same, in this embodiment of this application, the resistivity of the electrode footplate 12 is less than the resistivity of the heating cylinder 11, so that a heating amount at the electrode footplate 12 is small, which can weaken the reaction of the crucible and the fused silicon, thereby reducing the oxygen content in the crystal rod.

The heater 10 provided in this embodiment of this application may be specifically a main heater 10 in a single crystal furnace. By using a blank material with a large resistivity to manufacture the foregoing heating cylinder 11 and using a blank material with a low resistivity to manufacture the foregoing electrode footplate 12, the heating amount of the electrode footplate 12 can be reduced and the heating amount of the heating cylinder 11 can be increased while keeping a total resistance value unchanged, thereby effectively reducing a temperature of an R part and below the R part of the crucible, thereby reducing a reaction rate between the fused silicon and the crucible, and reducing the oxygen content in the produced crystal rod.

In the heater 10 provided in this embodiment of this application, during processing and manufacturing, there is no need to reduce a height of the heater 10 and increase the thickness of the electrode footplate 12. In other words, the effect of reducing the oxygen content in the crystal rod can be achieved while ensuring a conventional height of the heating cylinder 11, a conventional thickness of the electrode footplate 12, and the total resistance value of the heater 10.

Because the height of the heating cylinder 11 is not reduced, the heating amount of the heating cylinder 11 is not excessively concentrated, which does not affect the crystal pulling stability and the service life of the heater 10. In addition, because the height and thickness of the heater 10 can be kept consistent with those of a conventional heater in an existing single crystal furnace, the heater 10 in this embodiment of this application can achieve the effect of reducing the oxygen content in the crystal rod and also ensure the same service life as that of the conventional heater.

Optionally, in an embodiment of this application, the resistivity of the heating cylinder 11 is greater than or equal to 11 µΩ•m, and the resistivity of the electrode footplate 12 is less than or equal to 10 µΩ•m. That is, a blank material with a resistivity greater than or equal to 11 µΩ•m is used to manufacture the foregoing heating cylinder 11, and a blank material with a resistivity less than or equal to 10 µΩ•m is used to manufacture the foregoing electrode footplate 12.

Preferably, in an embodiment of this application, the resistivity of the heating cylinder 11 is greater than or equal to 12 µΩ•m, and the resistivity of the electrode footplate 12 is less than or equal to 9 µΩ•m. That is, a blank material with a resistivity greater than or equal to 12 µΩ•m is used to manufacture the foregoing heating cylinder 11, and a blank material with a resistivity less than or equal to 9 µΩ•m is used to manufacture the foregoing electrode footplate 12.

In an actual application, a material of the heater 10 provided in this embodiment of this application may be a graphite material and/or a carbon-carbon composite material, that is, the foregoing heater 10 is made of a graphite material and/or a carbon-carbon composite material. The heating cylinder 11 may be made of graphite and the electrode footplate 12 may be made of a carbon-carbon composite material, or the heating cylinder 11 may be made of a carbon-carbon composite material and the electrode footplate 12 may be made of a graphite material, or both the heating cylinder 11 and the electrode footplate 12 may be made of a carbon-carbon composite material and/or a graphite material, provided that the resistivity of the heating cylinder 11 is greater than or equal to 12 µΩ•m and the resistivity of the electrode footplate 12 is less than or equal to 9 µΩ•m.

In the heater 10 provided in this embodiment of this application, the heating cylinder 11 is of a cylindrical structure and may surround the crucible to heat the crucible. A cross-sectional dimension of the heating cylinder 11 matches a cross-sectional dimension of the crucible. In other words, a size of the accommodating space of the heating cylinder may be adjusted based on a size of the crucible.

In this embodiment of this application, there is no need to thicken both the first electrode footplate 121 and the second electrode footplate 122, which is conducive to cost reduction and on-site handling. Shapes and sizes of the first electrode footplate 121 and the second electrode footplate 122 are the same. In other words, heights, cross-sectional thicknesses, and cross-sectional widths of the first electrode footplate 121 and the second electrode footplate 122 are the same.

Optionally, in an implementation, the cross-sectional thicknesses of the first electrode footplate 121 and the second electrode footplate 122 both range from 25 mm to 40 mm, and the cross-sectional widths of the first electrode footplate 121 and the second electrode footplate 122 both range from 70 mm to 95 mm, so that an entire installation strength of the heater 10 can be effectively ensured. In addition, the heights of the first electrode footplate 121 and the second electrode footplate 122 can ensure that the heating cylinder 11 is risen to be opposite to a position of the crucible in the single crystal furnace.

In this embodiment of this application, thicknesses and widths of positions of the heating cylinder 11 in a radial direction are the same, and heights of the positions of the heating cylinder 11 in an axial direction are the same, so that heat is generated in each region of the heating cylinder 11 more evenly, thereby heating the crucible more properly.

Optionally, in an implementation, a thickness of the heating cylinder 11 in the radial direction ranges from 15 mm to 30 mm; and a height of the heating cylinder 11 in the axial direction ranges from 150 mm to 400 mm.

Optionally, the heating cylinder 11 of the heater 10 provided in this embodiment of this application includes a plurality of splicing members 111, and the plurality of splicing members 111 are connected to each other and combine to form the heating cylinder 11. The plurality of splicing members 111 are arranged to be connected to each other and combine to form the heating cylinder 11 of a cylindrical structure, which is convenient for actual processing and large-scale production. In an actual application, adjacent splicing members 111 of the splicing members 111 may be bonded as a whole by using graphite glue, or may be fixed by bolted connection, or may be fixed by using a connection plate.

Optionally, in an implementation, along an axial direction of the heating cylinder 11, projections of the splicing members 111 are all in a shape of an arc. In this case, the heating cylinder 11 formed by combination and connection of the splicing members 111 is in a shape of a cylinder, so that heat generated in each region of the heating cylinder 11 is uniform and stable.

Optionally, in a specific implementation, the first electrode footplate 121 and the second electrode footplate 122 are respectively fixedly connected to two splicing members distributed opposite to each other, to further ensure the structural stability and heat generation uniformity. In an actual application, the first electrode footplate 121 is fixed to a first splicing member by using graphite adhesive and/or a bolt, and the second electrode footplate 122 is fixed to a second splicing member by using graphite adhesive and/or a bolt. The first splicing member and the second splicing member are the foregoing two splicing members 111 distributed opposite to each other.

Optionally, in an implementation, an upper portion of each of the splicing members 111 is thinned. In this implementation, the upper portion of each of the splicing members 111 is thinned, so that the resistance of each of the splicing members 111 is increased, and a heating amount of the heating cylinder is further increased. Because an excessively thin edge affects a structural strength of the splicing member, an end portion of the splicing member 111 is easily cracked during handling and use. Therefore, a thickness of a thinned region of the upper portion of the splicing member 111 is set to be not less than 12 mm.

Optionally, in a specific implementation, each of the splicing members 111 is gradually thinned from a lower end to an upper end, so that when the splicing member 111 is energized to generate heat, a surface temperature of the splicing member increases evenly from bottom to top, thereby avoiding a shortened service life of the heater caused by local overheating, and heating the crucible more properly; and a minimum thickness of each of the splicing members is not less than 12 mm.

Optionally, in an implementation, the plurality of splicing members 111 include a plurality of U-shaped heating petals 112 in total. Each U-shaped heating petal 112 is formed by a part between two adjacent first slots 113 on the splicing members 111, and a second slot 114 is further provided at a middle position between the two adjacent first slots 113, so that the splicing members 111 are of a continuously curved snake-shaped structure. The first slot 113 is a groove extending from one end of the heating cylinder 11 toward the other end of the heating cylinder, and the second slot 114 is a groove extending from the other end of the heating cylinder 11 toward the end of the heating cylinder 11. A width of each groove is the same, and the width of each groove ranges from 10 mm to 50 mm.

Optionally, in a specific implementation, a quantity of the plurality of U-shaped heating petals 112 is 28 to 48. In other words, the heating cylinder 11 is formed by splicing and combining the 28 to 48 U-shaped heating petals 112.

In the heater 10 provided in this embodiment of this application, central angles corresponding to the splicing members 111 are the same or different. A quantity of the splicing members 111 may be two, three, four, five, six, or the like, provided that a sum of the central angles of the splicing members 111 is 360 degrees, so that the splicing members can be combined and connected to form the cylindrical heating cylinder 11.

Optionally, a central angle of the arc ranges from 60 degrees to 180 degrees, which facilitates processing and production of each splicing member 111.

Optionally, in a specific implementation, there are four splicing members 111. In this case, the central angle corresponding to each splicing member 111 is 90 degrees.

An embodiment of this application further provides another heater 10 for a single crystal furnace. As shown in FIG. 1, a heating cylinder 11 and an electrode footplate 12 are included. The heating cylinder 11 is a cylindrical structure arranged around a crucible in the single crystal furnace; the electrode footplate 12 includes a first electrode footplate 121 and a second electrode footplate 122; the first electrode footplate 121 supports one side of the heating cylinder 11 and is configured to connect to a first electrode of a power supply; the second electrode footplate 122 supports another side of the heating cylinder 11 and is configured to connect to a second electrode of the power supply; and a resistance ratio of the heating cylinder 11 to the electrode footplate 12 is (0.85-1):(0-0.15).

Because when the total resistance of the heater 10 is unchanged, a greater resistivity of the heating cylinder 11 and a smaller resistivity of the electrode footplate 12 are more conducive to crystal pulling production and achieving an oxygen reduction effect. In this embodiment of this application, the resistance ratio of the heating cylinder 11 to the electrode footplate 12 is set to (0.85-1):(0-0.15), that is, a percentage of the resistance of the heating cylinder 11 to the total resistance of the heater 10 is set to be greater than or equal to 85% and less than 100% and a percentage of the resistance of the electrode footplate 12 to the total resistance of the heater 10 is set to be less than or equal to 15%, so that a heating amount of the electrode footplate 12 is far lower than a heating amount of the heating cylinder 11. Therefore, there is no need to reduce a height of the heater 10 and increase a thickness of the electrode footplate 12. That is, an effect of reducing oxygen content in a crystal rod can be achieved while ensuring a conventional height of the heating cylinder 11, a conventional thickness of the electrode footplate 12, and a total resistance value of the heater 10.

Optionally, in an implementation, an absolute value of a resistance value of the heating cylinder 11 ranges from 25 mΩ to 60 mΩ, and an absolute value of a resistance value of the electrode footplate 12 ranges from 0 mΩ to 1 mΩ. That is, the resistance value of the electrode footplate 12 is controlled to continuously decrease to close to 0, which can reduce the heating amount of the electrode footplate 12 while ensuring that the heater 10 can generate heat based on a heating requirement of the crucible, so that a temperature of an R part and below the R part of the crucible is reduced more effectively.

Optionally, in an implementation, a resistivity of the electrode footplate 12 is less than a resistivity of the heating cylinder 11. The resistivity of the heating cylinder 11 and the resistivity of the electrode footplate 12 of the heater 10 are distinguished, a blank material with a low resistivity is used to form the electrode footplate 12 whose absolute value of the resistance value ranges from 0 mΩ to 1 mΩ, and a blank material with a high resistivity is used to form the heating cylinder 11 whose absolute value of the resistance value ranges from 25 mΩ to 60 mΩ. Therefore, there is no need to reduce the height of the heating cylinder 11 and increase the thickness of the electrode footplate 12, and the heating amount of the heating cylinder 11 can be effectively improved while the heating amount of the electrode footplate 12 is reduced, thereby reducing oxygen content in a head of a produced crystal rod, and facilitating cost reduction and on-site handling since the thickness of the electrode footplate 12 does not need to be additionally increased.

According to the heater 10 provided in this embodiment of this application, starting from the generation principle of oxygen in the crystal rod, by optimizing the structure of the heater 10 for the single crystal furnace, using a blank material with a low resistivity to manufacture the electrode footplate 12, and using a blank material with a high resistivity to manufacturing the heating cylinder 11, there is no need to reduce the height of the heating cylinder 11 and increase the thickness of the electrode footplate 12, so that the heating amount of the heating cylinder 11 can be effectively improved while the heating amount of the electrode footplate 12 is reduced, thereby reducing oxygen content in a head of a produced crystal rod.

A single crystal furnace including an existing heater A and a single crystal furnace including a heater B provided in the embodiments of this application are respectively used to carry out eight times of charging and crystal pulling. A total of 8 crystal rods RCZ1 to RCZ8 are successively grown by using the same crystal pulling process, and oxygen content in heads of the crystal rods is shown in FIG. 2.

It can be learned from FIG. 2 that, an average value of oxygen content in the heads of the crystal rods grown by using the existing heater A is 14.9 ppma, an average value of oxygen content in the heads of the crystal rods grown by using the heater B provided in the embodiments of this application is 13.3 ppma. An oxygen reduction effect is significant, and the crystal pulling stability is ensured since no other abnormalities and fluctuation phenomena occur during use.

In addition, this application further provides a single crystal furnace, including a furnace body and the heater 10 for a single crystal furnace described above installed in the furnace body.

The foregoing single crystal furnace embodiment includes the foregoing heater 10 for a single crystal furnace, and the same technical effects can be achieved. To avoid repetition, details are not described herein again, and for related parts, reference may be made to the description of the embodiments of the heater 10 for a single crystal furnace.

Based on the above, in this embodiment, the heater 10 for a single crystal furnace in this application includes a heating cylinder 11 and an electrode footplate 12; the heating cylinder 11 is a cylindrical structure arranged around a crucible in the single crystal furnace; the electrode footplate 12 includes a first electrode footplate 121 and a second electrode footplate 122; the first electrode footplate 121 supports one side of the heating cylinder 11 and is configured to connect to a first electrode of a power supply; the second electrode footplate 122 supports another side of the heating cylinder 11 and is configured to connect to a second electrode of the power supply; and a resistivity of the electrode footplate 12 is less than a resistivity of the heating cylinder 11. The resistivity of the heating cylinder 11 and the resistivity of the electrode footplate 12 of the heater 10 are distinguished, a blank material with a low resistivity is used to form the electrode footplate 12, and a blank material with a high resistivity is used to form the heating cylinder 11. Therefore, there is no need to reduce a height of the heating cylinder 11 and increase a thickness of the electrode footplate 12, and a heating amount of the heating cylinder 11 can be effectively improved while a heating amount of the electrode footplate 12 is reduced, thereby reducing oxygen content in a head of a produced crystal rod, and facilitating cost reduction of the footplate and on-site handling since the thickness of the electrode footplate 12 does not need to be additionally increased.

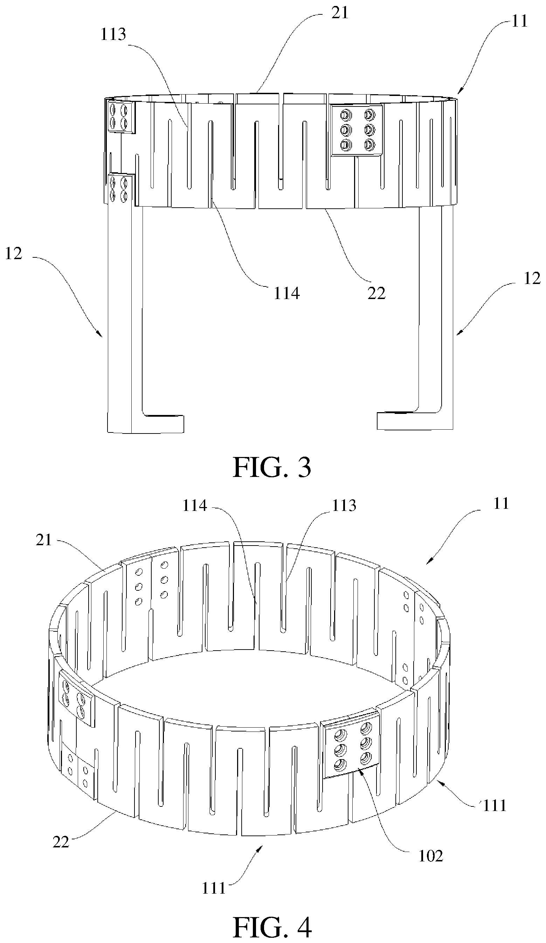

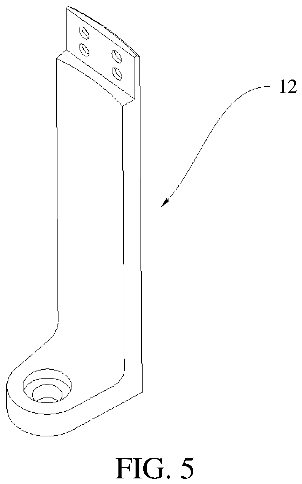

According to a specific implementation of this application, a heater 10 is provided. As shown in FIG. 3 to FIG. 5, the heater may include a heating cylinder 11 and an electrode footplate 12. The heating cylinder 11 is configured to cover an outer side of a crucible (not shown) of a single crystal furnace to heat the crucible. The heating cylinder 11 may include a first end surface 21 and a second end surface 22 opposite to the first end surface. The first end surface 21 is at an upper end of the heating cylinder 11, and the second end surface 22 is at a lower end of the heating cylinder 11. The heating cylinder 11 further includes a first slot 113 extending from the first end surface 21 toward the second end surface 22 and a second slot 114 extending from the second end surface 22 toward the first end surface 21. The first slot 113 and the second slot 114 are alternately arranged along a circumferential direction of the heating cylinder 11, so that a path of a current after the heater is energized on the heater is prolonged to increase the resistance, and the heater can provide more heat. A distance between an end of the second slot 114 and the first end surface 21 is less than a distance between an end of the first slot 113 and the second end surface 22, so that a high temperature region of the heating cylinder 11 is close to the upper end of the heating cylinder 11. The heater may include two electrode footplates 12, and the two electrode footplates 12 may be arranged opposite to each other, where upper ends of the electrode footplates 12 may be connected to the lower end of the heating cylinder 11, and lower ends of the two electrode footplates 12 may be electrically connected to a positive electrode and a negative electrode of the single crystal furnace respectively.

Through the foregoing technical solutions, in the heater provided in this application, by causing the distance between the end of the second slot 114 and the first end surface 21 to be less than the distance between the end of the first slot 113 and the second end surface 22, a position of the high temperature region of the heating cylinder 11 is adjusted, so that the position of the high temperature region is moved upward as a whole to be away from a bottom of the crucible while ensuring that the total resistance and a heating amount of the heating cylinder 11 are unchanged, to reduce baking to the bottom of the crucible, and reduce a temperature of the bottom of the crucible, thereby reducing the oxygen content in the head of the crystal rod while ensuring the crystal pulling stability and the production efficiency.

In a specific implementation of this application, a length of the first slot 113 may be not less than 81% of a length of the heating cylinder 11, and a length of the second slot 114 may be not greater than 89% of the length of the heating cylinder 11, to ensure that the first slot 113 and the second slot 114 each have a sufficient length, thereby ensuring that a path of a current on the heating cylinder 11 is long enough and the resistance of the heating cylinder 11 is large enough.

In a specific implementation of this application, the distance between the end of the first slot 113 and the second end surface 22 may be not less than 50 mm, and the distance between the end of the second slot 114 and the first end surface 21 may be not greater than 45 mm, so that the high temperature region is close to the upper end of the heating cylinder 11. In addition, each of the end of the first slot 113 and the end of the second slot 114 may be formed with a rounded corner with a radius of 5 mm.

In a specific implementation of this application, a width of the first slot 113 and a width of the second slot 114 may each range from 10 mm to 40 mm, to avoid fire striking and other safety accidents occur during use of the heater caused by an excessively narrow first slot 113 and an excessively narrow second slot 114, thereby prolonging a service life of the heater.

Referring to FIG. 3, a thickness of the electrode footplate 12 may range from 32 mm to 40 mm, and a width of the electrode footplate may range from 150 mm to 175 mm. Compared with a conventional electrode footplate, the thickness of the electrode footplate 12 is increased by 3 mm to 8 mm, and the width is increased by 5 mm to 10 mm, so that the thermal resistance of the electrode footplate 12 is lower than the thermal resistance of the conventional electrode footplate. Therefore, heat generated by the electrode footplate 12 after being energized is reduced, the baking to the bottom of the crucible is weakened, and the temperature of the bottom of the crucible is reduced, so that the oxygen content in the head of the monocrystalline silicon crystal rod can be reduced.

In a specific implementation of this application, as an option, referring to FIG. 3 and FIG. 4, the heating cylinder 11 may include a plurality of splicing members 111. That is, the heating cylinder 11 may be spliced by a plurality of splicing members 111. Every two adjacent splicing members 111 may be connected through a connection plate 102, so that the plurality of splicing members 111 combine to form a cylindrical structure. The connection plate 102 may be fixedly connected to the splicing member 111 by using a fastener. The fastener may be an M10 carbon-carbon bolt.

In addition, the splicing members 111 may be in the same shape, and a resistivity of each of the splicing members 111 and a resistivity of the connection plate 102 are consistent. Specifically, each of the splicing members 111 and the connection plate 102 may be made of a static graphite material, and each of the splicing members 111 and the connection plate 102 may be from the same blank material, to ensure that the resistivity of each of the splicing members 111 and the resistivity of the connection plate 102 are consistent.

In a specific implementation of this application, as an option, the heating cylinder 11 may be integrally formed.

In a specific implementation of this application, the heating cylinder 11 may be made of a graphite material or a carbon-carbon material. Because graphite has a good thermal conductivity, the heating cylinder 11 may form a closed circuit and generate heat when the heating cylinder is energized.

Based on the foregoing technical solutions, this application further provides a single crystal furnace, including a crucible (not shown) and the heater according to the foregoing technical solutions. A length of the heating cylinder 11 may be 0.35 times to 0.5 times a height of the crucible.

Through the foregoing technical solutions, the single crystal furnace provided in this application has the same technical effects as the heater in the foregoing technical solutions. To avoid unnecessary repetition, details are not described herein again. In addition, since the length of the heating cylinder 11 of the heater is 0.35 times to 0.5 times the total height of the crucible, the length of the heating cylinder 11 provided in this application is shortened by only 10 mm to 15 mm compared with a conventional heating cylinder, which can avoid impact on crystal pulling, and can further keep the high temperature region of the heating cylinder 11 away from the bottom of the crucible, thereby reducing the oxygen content in the head of the crystal rod.

There is a clear difference between entire-furnace head oxygen average value obtained by using the conventional single crystal furnace and the single crystal furnace provided in this application. As shown in Table 1 below, an example in which 7 crystal rods RCZ1 to RCZ7 are pulled in an entire furnace is used. Compared with the conventional single crystal furnace, for example, 7 crystal rods are pulled in the entire furnace, the background data represents data of the conventional single crystal furnace, and an entire-furnace head oxygen average value of the background data is 16 ppma; the experimental data represents data of the single crystal furnace provided in this application, an entire-furnace head oxygen average value of the experimental data is 14.3 ppma, which is reduced by 1.7 ppma compared with the background data, so that an oxygen reduction effect is significant.

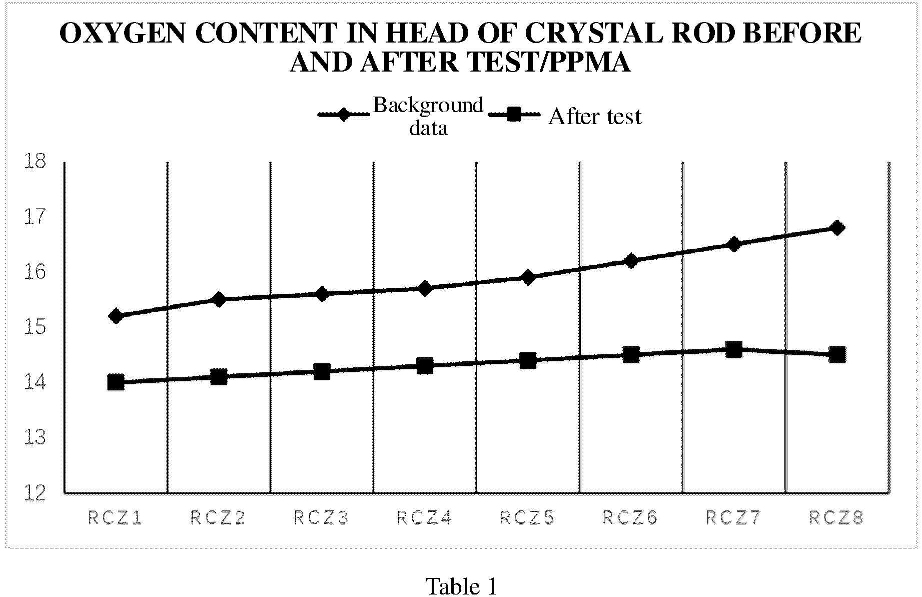

Preferred implementations of this application are described in detail above with reference to the accompanying drawings. However, this application is not limited to specific details of the foregoing implementations. Various simple modifications may be made to the technical solutions of this application within the scope of the technical idea of this application, and these simple modifications all fall within the protection scope of this application.

In addition, it should be noted that, specific technical features described in the foregoing specific implementations may be combined in any appropriate manner without contradiction. To avoid unnecessary repetition, various possible combinations are not described in this application.

In addition, various different implementations of this application may also be arbitrarily combined with each other without departing from the idea of this application, and such combinations shall also be considered as content disclosed in this application.

It should be noted that, the embodiments in this specification are all described in a progressive manner. Description of each embodiment focuses on differences from other embodiments, and same or similar parts among respective embodiments may be mutually referenced.

Although optional embodiments of the embodiments of this application have been described, once a person skilled in the art learns a basic creative concept, the person can make other changes and modifications to the embodiments. Therefore, the appended claims are intended to be construed as to cover the optional embodiments and all changes and modifications falling within the scope of the embodiments of this application.

Finally, it should be noted that, in this specification, the relational terms such as first and second are used only to differentiate an entity from another entity, and do not require or imply any actual relationship or sequence between these entities. Moreover, the terms "include", "comprise", and any other variants thereof are intended to cover non-exclusive inclusion. Therefore, an object or a terminal device that includes a series of elements not only includes such elements, but also includes other elements not clearly listed, or may include inherent elements of the object or the terminal device. Unless otherwise specified, an element limited by "including a/an..." does not exclude other same elements existing in the object or the terminal device that includes the element.

The technical solutions of this application are described above in detail. The principles and implementations of this application are described by using specific examples in this specification. Meanwhile, a person of ordinary skill in the art may make modifications to the specific implementations and application range according to the principle and implementations of this application. In conclusion, the content of this specification should not be construed as a limitation on this application.

## Claims

1. A heater for a single crystal furnace, comprising a heating cylinder and an electrode footplate, wherein
the heating cylinder is a cylindrical structure arranged around a crucible in the single crystal furnace;
the electrode footplate comprises a first electrode footplate and a second electrode footplate;
the first electrode footplate supports one side of the heating cylinder and is configured to connect to a first electrode of a power supply;
the second electrode footplate supports another side of the heating cylinder and is configured to connect to a second electrode of the power supply; and
a resistivity of the electrode footplate is less than a resistivity of the heating cylinder.

2. The heater according to claim 1, wherein the resistivity of the heating cylinder is greater than or equal to 11 µΩ•m, and the resistivity of the electrode footplate is less than or equal to 10 µΩ•m.

3. The heater according to claim 1, wherein the resistivity of the heating cylinder is greater than or equal to 12 µΩ•m, and the resistivity of the electrode footplate is less than or equal to 9 µΩ•m.

4. The heater according to claim 1, wherein a thickness of the heating cylinder in a radial direction ranges from 15 mm to 30 mm; a height of the heating cylinder in an axial direction ranges from 150 mm to 400 mm; and
cross-sectional thicknesses of the first electrode footplate and the second electrode footplate both range from 25 mm to 40 mm, and cross-sectional widths of the first electrode footplate and the second electrode footplate both range from 70 mm to 175 mm.

5. The heater according to claim 1, wherein the heating cylinder comprises a plurality of splicing members, and the plurality of splicing members are connected to each other and combine to form the heating cylinder.

6. The heater according to claim 5, wherein along an axial direction of the heating cylinder, projections of the splicing members are all in a shape of an arc.

7. The heater according to claim 6, wherein a central angle of the arc ranges from 60 degrees to 180 degrees.

8. The heater according to claim 5, wherein an upper portion of each of the splicing members is thinned, and a thickness of a thinned region of the upper portion of each of the splicing members is not less than 12 mm.

9. The heater according to claim 5, wherein each of the splicing members is gradually thinned from a lower end to an upper end, and a minimum thickness of each of the splicing members is not less than 12 mm.

10. The heater according to claim 1, wherein the first electrode footplate and the second electrode footplate are respectively fixedly connected to two splicing members distributed opposite to each other.

11. A heater for a single crystal furnace, comprising a heating cylinder and an electrode footplate, wherein
the heating cylinder is a cylindrical structure arranged around a crucible in the single crystal furnace;
the electrode footplate comprises a first electrode footplate and a second electrode footplate;
the first electrode footplate supports one side of the heating cylinder and is configured to connect to a first electrode of a power supply;
the second electrode footplate supports another side of the heating cylinder and is configured to connect to a second electrode of the power supply; and a resistance ratio of the heating cylinder to the electrode footplate is (0.85-1):(0-0.15).

12. The heater according to claim 11, wherein an absolute value of a resistance value of the heating cylinder ranges from 25 mΩ to 60 mΩ, and an absolute value of a resistance value of the electrode footplate ranges from 0 mΩ to 1 mΩ.

13. The heater according to claim 1 or 11, wherein the heating cylinder comprises a first end surface and a second end surface opposite to the first end surface, the heating cylinder further comprises a first slot extending from the first end surface toward the second end surface and a second slot extending from the second end surface toward the first end surface, the first slot and the second slot are alternately arranged along a circumferential direction of the heating cylinder, and a distance between an end of the second slot and the first end surface is less than a distance between an end of the first slot and the second end surface; and
the electrode footplate is connected to an end of the heating cylinder close to the second end surface.

14. The heater according to claim 13, wherein a length of the first slot is not less than 81% of a length of the heating cylinder, and a length of the second slot is not greater than 89% of the length of the heating cylinder.

15. The heater according to claim 13, wherein the distance between the end of the first slot and the second end surface is not less than 50 mm, and the distance between the end of the second slot and the first end surface is not greater than 45 mm.

16. The heater according to claim 13, wherein a width of the first slot and a width of the second slot both range from 10 mm to 40 mm.

17. The heater according to claim 13, wherein the heating cylinder comprises a plurality of splicing members, and every two adjacent splicing members are connected through a connection plate, so that the plurality of splicing members combine to form the cylindrical structure; and resistivities of the splicing members and the connection plate are consistent.

18. The heater according to claim 13, wherein the heating cylinder is integrally formed.

19. The heater according to claim 13, wherein the heating cylinder is made of a graphite material or a carbon-carbon material.

20. A single crystal furnace, comprising a furnace body and the heater for a single crystal furnace according to any one of claims 1 to 21 installed in the furnace body.

21. The single crystal furnace according to claim 20, further comprising a crucible, wherein a length of the heating cylinder is 0.35 times to 0.5 times a height of the crucible.
